# FASCICULE DE BREVET EUROPEEN

(11) **EP 3 273 259 B1**
(45) Date de publication et mention de la délivrance du brevet: **24.10.2018**
(21) Numéro de dépôt: 17180853.8
(22) Date de dépôt: 12.07.2017
(51) Int. Cl.: H01F 10/00, H01F 10/30, H01F 13/00, G01R 33/00, G01R 33/028, G01R 33/038, H01F 10/14, H01F 10/16

(54) **AIMANT PERMANENT COMPRENANT UN EMPILEMENT DE N MOTIFS**
DAUERMAGNET, DER EINEN STAPEL MIT N-MOTIVEN UMFASST
PERMANENT MAGNET COMPRISING A STACK OF N PATTERNS

(30) Priorité: 20.07.2016 FR 1656928
(43) Date de publication de la demande: 24.01.2018
(73) Titulaire: COMMISSARIAT À L'ÉNERGIE ATOMIQUE ET AUX ÉNERGIES ALTERNATIVES, 75015 Paris (FR)
(72) Inventeur: DELAET, Bertrand, 38190 BERNIN (FR); GIROUD, Sophie, 38120 SAINT-EGREVE (FR); HIDA, Rachid, 38210 CRAS (FR)
(74) Mandataire: GIE Innovation Competence Group

(56) Documents cités:
- WO-A1-2011/028185
- FR-A1- 2 774 774
- FR-A1- 3 020 497

## Description

L'invention concerne un aimant permanent ainsi qu'un capteur de champ magnétique incorporant cet aimant permanent. L'invention concerne également un procédé de fabrication de cet aimant permanent.

Des capteurs connus de champ magnétique incorporent des aimants permanents pour mesurer l'amplitude, dans une direction donnée, d'un champ magnétique à mesurer. De tels capteurs sont décrits, par exemple, en référence à la figure 4 de la demande US2011/0151589 ou en référence aux figures 1A à 8 de la demande WO2010/0084165.

Les aimants permanents utilisés dans ces capteurs, contrairement aux couches piégées (« pinned layer » en anglais) utilisées dans les vannes de spin ou GMR (« Giant Magnetoresistance ») et dans les jonctions tunnels ou TMR (« Tunnel Magnetoresistance »), doivent générer un champ magnétique important. Pour rappel, dans les vannes de spin et les jonctions tunnels, le champ magnétique généré par la couche piégée doit au contraire être faible pour permettre à la direction d'aimantation de la couche libre de tourner et de s'aligner sur la direction d'un champ magnétique extérieur. Ainsi dans le cas de structures dynamiques, comme des structures MRAM (Magnetoresistive Random Access Memory) par exemple, l'aimantation évolue lors de l'utilisation de la structure. Au contraire, dans les aimants permanents, la direction d'aimantation est figée.

Pour obtenir un champ magnétique important, dans les capteurs connus, l'aimant permanent est réalisé par un empilement de couches ferromagnétiques et de couches antiferromagnétiques. Typiquement, un tel aimant permanent comporte un empilement de N motifs empilés les uns sur les autres dans une direction d'empilement, où N est un nombre entier supérieur ou égal à deux, chaque motif comportant :
- une couche antiferromagnétique basse,
- une couche antiferromagnétique haute, et
- une couche ferromagnétique située entre les couches antiferromagnétiques basse et haute et dont la direction d'aimantation est figée, par un couplage d'échange, avec la couche antiferromagnétique basse ou haute de ce motif,
les directions d'aimantation des couches ferromagnétiques, qui sont couplées par couplage d'échange avec la couche antiferromagnétique basse ou haute du même motif, étant toutes identiques les unes aux autres.

Dans les aimants permanents connus chaque couche ferromagnétique est coincée entre deux couches antiferromagnétiques. De tels modes de réalisation d'un aimant permanent sont décrits en référence à la figure 1A de la demande US 2011/0151589 et en référence aux figures 10A et 10B de la demande WO 2010/0084165.

Dans cette description, lorsqu'on indique qu'une couche ou une sous-couche est « réalisé en X » ou lorsqu'on parle d'une « couche X » ou d'une « couche de X » ou d'une « couche en X », on désigne une couche ou une sous-couche dans laquelle le matériau X représente plus de 95 % de sa masse, et généralement, plus de 98 % ou 99 % de sa masse.

Par couches ferromagnétiques et antiferromagnétiques, on désigne des couches réalisées, respectivement, en matériau ferromagnétique et en matériau antiferromagnétique.

Par la suite, le champ magnétique d'un aimant permanent comportant un empilement de couches ferromagnétiques et antiferromagnétiques est considéré comme important si le moment magnétique total de cet aimant par unité de surface est supérieur à 50 x 10⁻³ A et, de préférence, supérieur à 500 x 10⁻³ A ou 1000 x 10⁻³ A.

Le moment magnétique par unité de surface d'un aimant permanent comportant un empilement de couches ferromagnétiques et antiferromagnétique peut facilement être mesuré. Par exemple, le moment magnétique de l'aimant permanent est mesuré par la méthode VSM (« Vibrating Sample Magnetometry »). Cette méthode est bien connue. Elle est par exemple décrite dans les articles suivants :
- Simon FONER, «Versatile and Sensitive Vibrating-Sample Magnetometer », The review of scientific instrucments, Volume 30, number 7, juillet 1959,
- Christian Albrechts, « Vibrating Sample Magnetometry », Université de Kiel, M106, 2011.

Le moment magnétique ainsi mesuré est alors divisé par le volume de matériau ferromagnétique contenu dans cet aimant pour obtenir son aimantation. Quel que soit l'empilement, les dimensions des couches ferromagnétiques peuvent être facilement mesurées, par exemple, par observation de coupes verticales de cet empilement avec un microscope. En particulier, ces observations permettent de mesurer l'épaisseur tᵢ de chaque couche ferromagnétique. Enfin, l'aimantation ainsi obtenue est multipliée par la somme des épaisseurs tᵢ de chaque couche ferromagnétique pour obtenir le moment magnétique de cet aimant par unité de surface. Généralement, les couches ferromagnétiques de l'empilement ont toutes la même surface dans un plan perpendiculaire à la direction d'empilement de ces couches. Par conséquent, on peut aussi diviser le moment magnétique mesuré pour l'aimant par la surface des couches ferromagnétiques, ou par la surface de l'aimant permanent si elle est égale à la surface des couches ferromagnétiques, pour obtenir le moment magnétique par unité de surface.

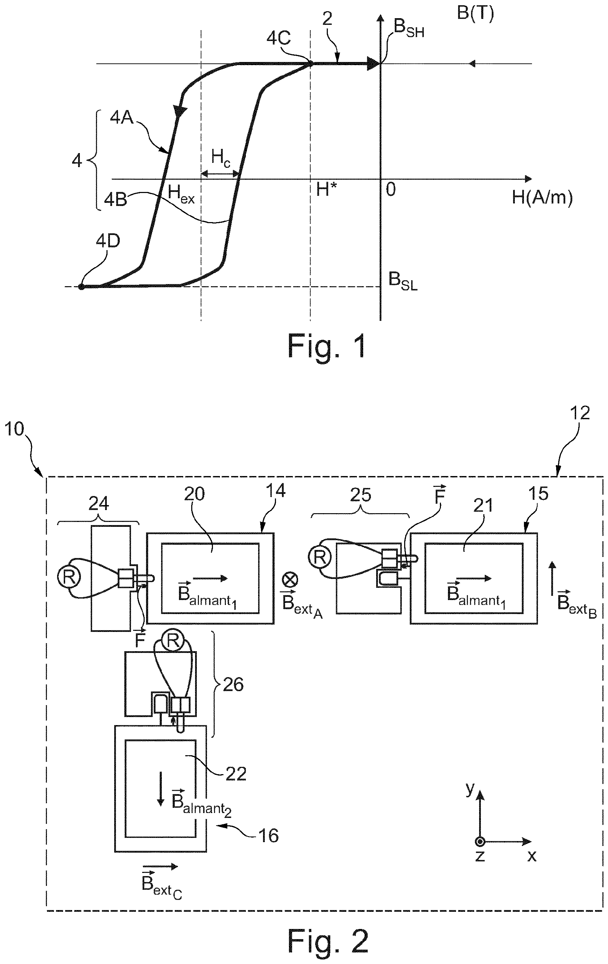

L'aimantation d'un tel aimant permanent, présente typiquement un cycle d'hystérésis tel que celui représenté sur la figure 1.

La figure 1 va maintenant être utilisée pour définir certains termes. La courbe 2 représente de façon schématique l'évolution de l'aimantation, notée B sur les figures, de l'aimant permanent en fonction du champ magnétique H. Plus précisément, l'aimantation B varie entre deux valeurs extrêmes B_{SL} et B_{SH}. Lorsque l'aimantation de l'aimant permanent approche la valeur B_{SH}, son aimantation n'augmente plus significativement même si le champ magnétique H augmente. Pour simplifier la figure 1, cette augmentation non significative de l'aimantation B en fonction du champ H a été représenté par une ligne horizontale. On dit alors que l'aimant est saturé. Le même phénomène se produit lorsque l'aimantation approche la valeur B_{SL} et que le champ magnétique continue à diminuer. Entre ces deux valeurs extrêmes, la courbe 2 définit un cycle 4 d'hystérésis. Le cycle 4 comporte :
- une courbe 4A qui descend au fur et à mesure que le champ magnétique H diminue, et
- une courbe 4B qui monte au fur et à mesure que le champ magnétique H augmente.

Les courbes 4A et 4B se rejoignent d'un côté au voisinage d'un point 4C et de l'autre côté au voisinage d'un point 4D. Entre ces points 4C et 4D, les courbes 4A et 4B sont distinctes. Au-delà du point 4C et en-deçà du point 4D, les courbes 4A et 4B sont sensiblement confondues et pour des champs importants en valeur absolue on tend vers la saturation. Ici, le point 4C est le plus proche de l'axe des ordonnées.

Au niveau des points 4C et 4D, l'écart entre les courbes 4A et 4B est égal à 2 % de la valeur B_{R}, B_{R} correspondant à l'aimantation à champ nul (c'est-à-dire pour le champ H=0). Sur la figure 1 du fait de la simplification de la courbe au niveau de la saturation, B_{R} correspond à B_{SH.}

Dans le cas des aimants permanents formés par l'empilement de couches ferromagnétiques et antiferromagnétiques, le cycle 4 d'hystérésis est, généralement, décalé, par exemple comme représenté sur la figure 1. Plus précisément, le cycle 4 est décalé, par rapport à l'axe des ordonnées, d'une valeur Hₑₓ appelée par la suite champ d'échange Hₑₓ ou champ Hₑₓ. Ce champ Hₑₓ est également connu sous le terme anglais de « exchange bias ». Typiquement, la valeur du champ Hₑₓ correspond à la valeur de l'abscisse du point situé à mi-distance entre les deux points où le cycle 4 coupe l'axe des abscisses. Dans ce graphe, l'axe des abscisses représente le champ magnétique H.

Le champ coercitif H_{c} ou champ H_{c} de l'aimant permanent est la demi-largeur du cycle 4. Typiquement, sa valeur est prise égale à la différence entre la valeur du champ Hₑₓ et un point d'intersection du cycle 4 avec l'axe des abscisses.

On définit également le champ H* comme étant le plus petit champ magnétique à partir duquel l'hystérésis de l'aimant permanent disparaît, c'est-à-dire comme précisé ci-dessus, le champ magnétique pour lequel l'hystérésis est inférieure à 2% de la valeur B_{R}. Ici, la valeur du champ H* est égale à la valeur de l'abscisse du point 4C.

Il est souhaitable que l'aimant présente un champ H* aussi éloigné que possible de l'axe des ordonnées. En effet, cela améliore l'insensibilité de cet aimant aux perturbations magnétiques extérieures. Cela permet aussi d'améliorer la dynamique des capteurs de champ magnétique qui incorporent de tels aimants. Dans ce texte, on dit que le champ H* est amélioré lorsqu'il s'éloigne encore plus de l'axe des ordonnées. A l'inverse, on dit que le champ H* est détérioré s'il se rapproche de l'axe des ordonnées. Ce champ H* dépend des champs Hₑₓ, H_{c} et de la forme du cycle qui peut être approximée par un paramètre appelé « squareness » qui est défini plus en détail ultérieurement et qui est fonction des matériaux et des procédés utilisés.

Il faut également que l'aimant génère un champ magnétique important. Le champ magnétique généré par l'aimant augmente en fonction du nombre N de motifs de l'empilement. Il est donc souhaitable d'augmenter ce nombre N. Or, il a été observé que plus le nombre N augmente plus le champ H* se détériore. Il existe donc une contradiction entre :
- d'un côté la nécessité d'augmenter le nombre N de motifs pour générer un champ magnétique plus important, et
- d'un autre côté, la nécessité de limiter le nombre N de motifs pour conserver un champ H* aussi éloigné que possible de l'axe des ordonnées.

De l'état de la technique est également connu de : WO2011/028185A1 et FR2774774A1.

L'invention vise à remédier à cette contradiction et à obtenir un aimant permanent qui, pour un même nombre N de motifs, présente un champ H* plus éloigné de l'axe des ordonnées. A cet effet, l'invention a pour objet un aimant permanent conforme à la revendication 1.

Par couche de croissance, on entend une couche présentant en surface une rugosité et un paramètre de maille adaptés à la croissance de la couche antiferromagnétique basse du motif suivant. Il a été découvert que l'introduction d'une couche de croissance en matériau non magnétique entre les couches antiferromagnétiques de deux motifs successifs permettait d'améliorer champ H* par rapport à un aimant identique mais dépourvu de tels couches croissance. L'une des hypothèses pour expliquer les résultats observés est que la couche de croissance aurait une influence sur la rugosité de l'interface entre les couches antiferromagnétique et ferromagnétique situées juste au-dessus et donc qu'elle améliorerait le couplage d'échange entre ces couches antiferromagnétique et ferromagnétique de même que le champ coercitif H_{c} et la « squareness », d'où une amélioration du champ H*.

La couche de croissance peut avoir une structure similaire à la couche connue sous le terme de « couche de germination » ou « seed layer » en anglais. La couche de germination est toujours située sous l'empilement. En effet, elle est utilisée pour créer des conditions favorables à la croissance des couches suivantes de l'empilement. Par contre une telle couche de germination n'est jamais introduite entre deux motifs successifs de l'empilement. En effet, une fois que les conditions favorables à la croissance des couches suivantes ont été créées par la couche de germination, il n'y a aucune raison d'introduire dans l'empilement une couche de germination supplémentaire puisque les conditions de croissance des couches sont déjà favorables. Au contraire, l'homme du métier sait que l'ajout de couches supplémentaires dans l'empilement complexifie sa fabrication de sorte qu'il n'est pas incité à ajouter de telles couches supplémentaires s'il n'y voit aucun avantage.

Les inventeurs ont réalisé que si on reste sur un volume total des couches de croissance limité, c'est-à-dire typiquement inférieur à 25% du volume total de l'empilement, l'amélioration du champ H* compense largement la complexification du procédé de fabrication causée par l'ajout des couches de croissance.

Enfin, il est souligné que la couche de germination est placée sous l'empilement d'une couche antiferromagnétique et d'une couche ferromagnétique. Ainsi, si l'homme du métier souhaitait introduire une couche de germination dans les empilements de motifs décrits dans les demandes US2011/0151589 et WO2010/0084165, alors il obtiendrait un empilement dans lequel la couche de germination est située sous la couche antiferromagnétique du motif suivant et sur la couche ferromagnétique du motif précédent. Or, un aimant comportant un tel empilement ne présente pas les avantages de l'aimant revendiqué.

Les modes de réalisation de cet aimant permanent peuvent comporter une ou plusieurs des caractéristiques des revendications dépendantes.

Ces modes de réalisation de l'aimant permanent présentent en outre les avantages suivants :
- Le fait que la couche de croissance comporte du tantale lui permet de remplir en plus la fonction de barrière apte à limiter la diffusion du manganèse. Ceci permet d'améliorer encore plus le champ H*.
- Le fait que la couche de croissance comporte une sous-couche métallique directement en contact avec la couche antiferromagnétique du motif suivant permet d'améliorer encore plus le champ H*.
- Plus l'empilement comporte un nombre élevé de couches de croissance, plus le champ H* s'améliore.
- L'utilisation d'un couplage RKKY dans un motif de l'aimant permet de piéger la direction d'aimantation d'une couche ferromagnétique sans utiliser une couche antiferromagnétique supplémentaire. Cela permet d'améliorer encore plus le champ H*.
- L'introduction d'une sous-couche en CoFeB à l'intérieur de la couche ferromagnétique permet également d'améliorer encore plus le champ H*.

L'invention a également pour objet un capteur de champ magnétique conforme à la revendication 11.

Enfin, l'invention a également pour objet un procédé de fabrication de l'aimant permanent revendiqué conforme à la revendication 12.

L'invention sera mieux comprise à la lecture de la description qui va suivre, donnée uniquement à titre d'exemple non limitatif tout en se référant aux dessins sur lesquels :
- la figure 1 est une illustration schématique du cycle d'hystérésis d'un aimant permanent réalisé à partir d'un empilement de couches ferromagnétiques et antiferromagnétiques ;
- la figure 2 est une illustration schématique, en vue de dessus, d'un capteur de champ magnétique ;
- la figure 3 est une illustration schématique, en coupe verticale longitudinale, d'un aimant permanent du capteur de la figure 2 ;
- la figure 4 est un organigramme d'un procédé de fabrication de l'aimant permanent de la figure 3 ;
- les figures 5 et 6 sont des illustrations schématiques, en coupe verticale longitudinale, d'autres modes de réalisation possibles d'un motif de l'aimant permanent de la figure 3.

Dans ces figures, les mêmes références sont utilisées pour désigner les mêmes éléments. Dans la suite de cette description, les caractéristiques et fonctions bien connues de l'homme du métier ne sont pas décrites en détail.

La figure 2 représente un capteur 10 de champ magnétique. Ce capteur 10 est identique au capteur décrit en référence à la figure 8 de la demande WO2010/084165, sauf en ce qui concerne la structure des aimants permanents utilisés. Ainsi, seule une brève description de l'architecture générale de ce capteur est donnée pour illustrer un exemple de réalisation d'un tel capteur.

Ce capteur 10 comprend :
- un substrat 12 s'étendant essentiellement dans un plan horizontal parallèle à des directions orthogonales X et Y, et
- trois magnétomètres 14 à 16 mono-axes réalisés sur le substrat 12.

Une direction Z, perpendiculaire aux directions X et Y, représente la verticale. Par la suite, les figures suivantes sont orientées par rapport à ce même repère X, Y, Z. De plus, les termes tels que « au-dessus », « en dessous », « en bas », « en haut » sont définis par rapport à cette direction Z.

Les magnétomètres 14 à 16 mesurent l'amplitude du champ magnétique à mesurer dans les directions, respectivement, Z, Y et X. A cet effet, chaque magnétomètre 14 à 16 comporte :
- un aimant permanent, respectivement 20 à 22, apte à se déplacer par rapport au substrat 12, et
- un transducteur, respectivement 24 à 26, apte à transformer le déplacement de l'aimant permanent en une variation de courant ou de tension correspondante.

Par exemple, les transducteurs 24 à 26 sont des transducteurs piézorésistifs. Typiquement, ces transducteurs sont fixés, sans degré de liberté, d'un côté sur le substrat 12 et, d'un autre côté, à l'aimant permanent.

Ici, les aimants permanents 20 à 22 sont identiques à l'exception du fait que la direction du moment magnétique globale de l'aimant permanent 22 est perpendiculaire à celle des aimants permanents 20 et 21. Dès lors, seule une description détaillée de l'aimant permanent 20 est donnée par la suite.

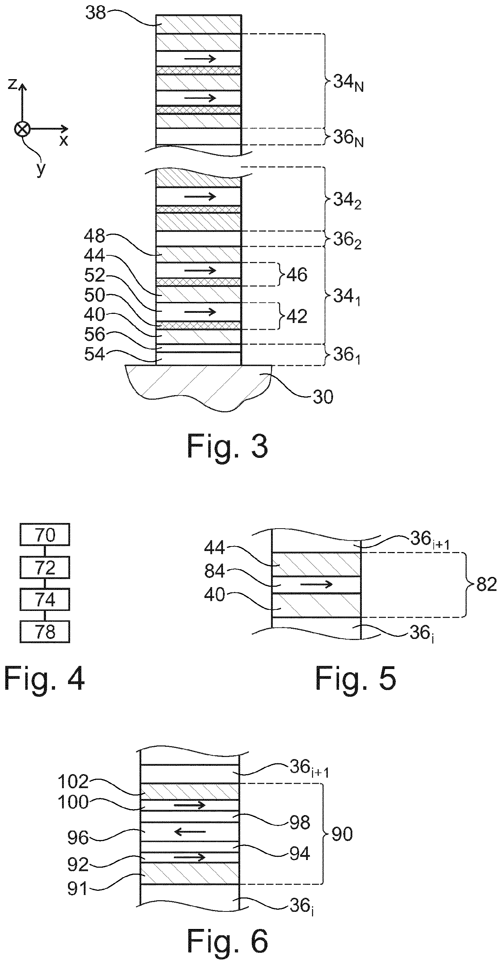

La figure 3 représente l'aimant permanent 20 déposé sur un socle 30 mobile par rapport au substrat 12. Par exemple, le socle 30 est obtenu par gravure du substrat 12. Seule une portion de ce socle 30 est représentée sur la figure 3.

L'aimant 20 est formé d'un empilement, dans une direction d'empilement, de couches ferromagnétiques et antiferromagnétiques. Ici, la direction d'empilement est parallèle à la direction Z. Sur la figure 3 et les suivantes, les conventions suivantes sont adoptées :
- les couches antiferromagnétiques sont hachurées,
- la direction du moment magnétique d'une couche ferromagnétique est représentée par une flèche,
- les lignes ondulées au milieu de l'empilement indiquent qu'une portion intermédiaire de cet empilement n'a pas été représentée,
- les proportions entre les épaisseurs des différentes couches ne sont pas respectées pour améliorer la lisibilité des figures, et
- la proportion entre la longueur L et la hauteur de l'empilement n'est pas respectée pour réduire la taille des figures dans la direction longitudinale de l'empilement.

Ici, l'empilement présente une forme parallélépipédique et un facteur de forme supérieur ou égal à 2, 5 ou 20, voire même supérieur à 100 ou 1000. Dans ce mode de réalisation, le facteur de forme est défini comme étant le rapport de la longueur L sur la largeur W de l'empilement. Ici, la longueur est parallèle à la direction X et la largeur W est parallèle à la direction Y.

Plus le facteur de forme est important et plus il est facile d'aligner la direction d'aimantation des couches ferromagnétiques sur la direction longitudinale de l'empilement lors de sa fabrication. Par exemple, la largeur de l'empilement est inférieure à 20 µm ou 10 µm et la longueur L est supérieure à 50 µm ou 100 µm ou 1 mm. La hauteur de l'empilement est généralement supérieure à 100 µm ou 500 µm. Cette hauteur est mesurée entre la couche de l'empilement la plus proche du socle 30 et la couche de ce même empilement la plus éloignée du socle 30.

Ici, l'empilement de couches ferromagnétiques et antiferromagnétiques est composé :
- d'un motif 34 répété N fois,
- d'une couche de croissance 36 située juste en dessous de chaque motif 34,
- d'une couche 38 d'encapsulation déposée au sommet de cet empilement.

La couche 38 est destinée à protéger l'aimant permanent des agressions chimiques et/ou physiques de l'environnement extérieur. Cette couche 38 est réalisée dans un matériau non magnétique. Par matériau non magnétique, on désigne ici un matériau dépourvu de propriété magnétique susceptible de perturber le fonctionnement de l'aimant permanent 20. Généralement, il s'agit d'un matériau dont les propriétés magnétiques sont nulles ou non mesurables.

Typiquement, la couche 38 est réalisée en Tantale (Ta) ou en Molybdène (Mo) ou en Ruthénium (Ru) ou une combinaison de ces matériaux. Par exemple, la couche 38 est réalisée en tantale (Ta) et son épaisseur est supérieure ou égale à 10 nm.

Dans ce mode de réalisation, la direction d'empilement des motifs 34 est parallèle et de même sens que la direction Z. Les premières occurrences du motif 34 et de la couche de croissance 36 dans l'empilement, c'est-à-dire celles qui sont les plus proches du socle 30, portent, respectivement, les références numériques 34₁ et 36₁. Les deuxièmes occurrences du motif 34 et de la couche 36 immédiatement au-dessus de ces premières occurrences 34₁ et 36₁ portent les références 34₂ et 36₂, et ainsi de suite jusqu'aux dernières occurrences 34_{N} et 36_{N}.

Ici, chaque occurrence 34₁ à 34_{N} est directement empilée sur une occurrence respective de la couche 36. En particulier, deux occurrences successives du motif 34 dans la direction Z sont systématiquement séparées l'une de l'autre uniquement par une seule occurrence de la couche 36. Dans ce mode de réalisation, la première occurrence 36₁ de la couche 36 est utilisée comme couche de germination.

Le nombre N de répétitions du motif 34 est généralement choisi pour atteindre une hauteur souhaitée de l'empilement. Cette hauteur dépend de l'application envisagée. N est cependant systématiquement supérieur ou égal à deux et, de préférence, supérieur à 5 ou 10 ou 20. N est également généralement inférieur à 50 ou 100. Ici, N est également choisi de manière à atteindre le moment magnétique par unité de surface recherché pour l'aimant permanent.

Dans ce mode de réalisation, les différentes occurrences du motif 34 sont toutes identiques les unes aux autres et seule l'occurrence 34₁ va donc être décrite en détail.

Ici, à titre d'illustration, l'occurrence 34₁ est composée successivement dans la direction Z :
- d'une couche antiferromagnétique 40,
- d'une couche ferromagnétique 42 dont la direction d'aimantation est piégée par couplage d'échange avec la couche antiferromagnétique 40,
- d'une couche antiferromagnétique 44 qui piège elle aussi, par couplage d'échange, la direction d'aimantation de la couche ferromagnétique 42,
- d'une couche ferromagnétique 46 dont la direction d'aimantation est aussi piégée par couplage d'échange avec la couche antiferromagnétique 44, et
- d'une couche antiferromagnétique 48 qui piège elle aussi, par couplage d'échange, la direction d'aimantation de la couche ferromagnétique 46.

Dans cet exemple de réalisation, les couches antiferromagnétiques 44 et 46 sont identiques à la couche antiferromagnétique 40. De même, la couche ferromagnétique 46 est identique à la couche ferromagnétique 42. Ainsi, par la suite, seules les couches 40 et 42 sont décrites plus en détail.

Dans cette demande, par couche « antiferromagnétique » on désigne une couche horizontale d'épaisseur constante dans laquelle le ou les matériaux antiferromagnétiques représentent plus de 95 % ou 98 % ou 99 % de la masse de cette couche.

Les matériaux antiferromagnétiques utilisés sont par exemple choisis dans le groupe constitué :
- des alliages de manganèse,
- du NiO, et
- du Fe₂O₃.

Les alliages de manganèse antiferromagnétiques sont typiquement le PtMn, NiMn, PdPtMn, FeMn et IrMn. Dans cet exemple, le matériau antiferromagnétique choisi pour la couche 40 est l'alliage IrMn.

Dans cette demande, par couche « ferromagnétique » on désigne une couche horizontale d'épaisseur constante dans laquelle le ou les matériaux ferromagnétiques représentent plus de 95 % ou 98 % ou 99 % de la masse de cette couche.

Les matériaux ferromagnétiques utilisés sont par exemple choisis dans le groupe constitué :
- des alliages à base de Fe et/ou Co et/ou Ni, comme par exemple CoFe, NiFe, CoFeSi..., et
- des alliages d'Heusler comme par exemple Cu₂MnSn ou Co₂MnSi ou Ni₂MnAl....

Dans ce mode de réalisation, la direction d'aimantation de la couche 42, c'est-à-dire la direction de son moment magnétique, est parallèle et de même sens que la direction X. Typiquement, l'amplitude de l'aimantation à saturation de la couche 42 est supérieure ou égale à 400000 A/m ou 800000 A/m voire 1600000 A/m.

Cette direction d'aimantation est piégée par un couplage d'échange avec les couches 40 et 44. Un couplage d'échange entre une couche ferromagnétique et une couche antiferromagnétique apparaît si :
- la couche ferromagnétique est directement déposée sur la couche antiferromagnétique, ou
- uniquement séparée de la couche antiferromagnétique par une (ou plusieurs) très fine(s) couche(s) non-magnétique(s) dont l'épaisseur totale est inférieure à 0,5 nm et, de préférence, inférieure à 0,4 nm ou 0,2 nm.

Le couplage d'échange entre les couches ferromagnétique et antiferromagnétique est bien connu. Par exemple, le lecteur peut se référer à l'article suivant : J. Nogués et Ivan K. Schuller, « Exchange bias » Journal of magnetism and magnetic materials 192 (1999), 203-232.

Dans ce mode de réalisation, chaque couplage d'échange est obtenu en déposant directement la couche ferromagnétique sur la couche antiferromagnétique.

La présence du couplage d'échange entre la couche ferromagnétique et la couche antiferromagnétique se traduit notamment par un décalage, par exemple vers la gauche comme illustré sur la figure 1, du cycle d'hystérésis de l'assemblage de ces deux couches et donc par l'apparition d'un champ Hₑₓ non nul.

Ici, les épaisseurs des couches 40 et 42 sont choisies pour obtenir un bon couplage d'échange entre ces deux couches. Dans cette description, on considère que le couplage d'échange est bon si cela se traduit par l'apparition d'un champ d'échange Hₑₓ dont la valeur absolue est supérieure à 4000 A/m et, de préférence, supérieure à 8000A/m ou 16000 A/m) ou 40000 A/m à 25°C. Les champs Hₑₓ et H_{c} d'un empilement comportant seulement les couches 40 et 42 peut être mesuré expérimentalement ou obtenu par simulation numérique.

Un bon couplage d'échange permet en cas de perturbation magnétique extérieure importante de revenir à l'état initial après la disparition de cette perturbation.

L'épaisseur des couches 40 et 42 est, par exemple, déterminée par expérimentation en testant successivement des épaisseurs différentes pour un empilement formé seulement d'une couche antiferromagnétique et d'une couche ferromagnétique réalisées dans les mêmes matériaux que les couches 40 et 42. Pour les matériaux antiferromagnétiques et ferromagnétiques les plus courants, les épaisseurs appropriées sont connues de l'homme du métier. Par exemple, typiquement, l'épaisseur de la couche 40 est comprise entre 5 nm et 100 nm et, de préférence, entre 5 nm et 25 nm. L'épaisseur de la couche 42 est souvent comprise entre 0,5 nm et 50 nm ou 100 nm. De préférence, l'épaisseur de la couche 42 est supérieure à 10 nm. Dans cet exemple, l'épaisseur de la couche 40 est comprise entre e_{FM}/3 et 3e_{FM} pour obtenir un bon couplage d'échange, où e_{FM} est l'épaisseur de la couche 42. Ici, l'épaisseur de la couche 40 est de 7 nm tandis que l'épaisseur de la couche 42 est de 21 nm.

L'épaisseur de la couche 44 est choisie de manière à obtenir un bon couplage d'échange avec les couches 42 et 46. Par conséquent, la couche 44 peut, si nécessaire, être plus épaisse que les couches 42 et 46. Dans cet exemple, les épaisseurs des couches 44 et 48 sont identiques à l'épaisseur de la couche 40.

Le moment magnétique global de l'aimant permanent 20 est proportionnel à la somme des moments magnétiques de toutes les couches 42 et 46 de l'empilement.

Ici, pour améliorer le champ H*, la couche 42 comporte une sous-couche 50 de CoFeB, et une sous-couche 52 réalisée dans un matériau ferromagnétique différent du CoFeB.

Dans cette description, la composition d'une couche ou d'une sous-couche est notée de la façon suivante : AₓB_{y}, où :
- A et B sont les symboles des éléments chimiques composant cette couche ou sous-couche, et
- l'indice x est la masse de l'élément A dans la couche ou sous-couche exprimé en pourcentage de la masse de cette couche ou sous-couche, et
- l'indice y est la masse de l'élément B dans la couche ou sous-couche exprimé en pourcentage de la masse de cette couche ou sous-couche.

Ici, la composition de la sous-couche 50 est notée CoₓFe_{y}B_{z}. De préférence, la composition de la sous-couche 50 est telle que z est compris entre 10 % et 30 % en masse atomique. Avantageusement on choisira également x et y supérieurs ou égaux chacun à 10%.

Par exemple, la composition de la sous-couche 50 est la suivante : Co₂₈Fe₅₂B₂₀ ou Co₄₀Fe₄₀B₂₀ ou Co₄₃Fe₄₃B₁₄.

L'épaisseur de la sous-couche 50 est supérieure à 0,05 nm ou 0,1 nm et, de préférence, supérieure à 0,5 nm. De préférence, l'épaisseur maximale de la sous-couche 50 est inférieure à 10 nm et, avantageusement, inférieure à 5 nm ou 2 nm.

Dans ce mode de réalisation, la sous-couche 50 est directement déposée sur la couche 40.

La sous-couche 52 est, par exemple, réalisée dans un matériau ferromagnétique choisi dans le groupe composé du cobalt, du nickel, du fer et de leurs alliages. Par exemple, le matériau ferromagnétique est souvent du CoFe ou NiFe. Ici, la sous-couche 52 est réalisée en CoFe. La composition de la sous-couche 52 est notée CoₐFe_{b}. Les pourcentages a, b de Cobalt et de Fer dans la sous-couche 52 sont différents des pourcentages x, y de ces mêmes éléments dans la sous-couche 50. Par exemple, la sous-couche 52 est réalisée en Co₃₅Fe₆₅ ou en Co₈₀Fe₂₀.

L'épaisseur e₅₂ de la sous-couche 52 est strictement supérieure à l'épaisseur e₅₀ de la sous-couche 50. Typiquement, l'épaisseur e₅₂ est au moins deux ou cinq ou dix ou vingt fois supérieure à l'épaisseur e₅₀.

Le motif 34₁ débute et termine par une couche antiferromagnétique. Grâce à cela, chaque occurrence 36₂ à 36_{N} de la couche de croissance 36 est systématiquement et directement interposée entre la couche antiferromagnétique haute 48 du motif précédent et la couche ferromagnétique basse 40 du motif suivant.

Dans ce mode de réalisation, les différentes occurrences du motif 36 sont toutes identiques les unes aux autres et seule l'occurrence 36₂ va donc être décrite en détail.

La couche de croissance 36₂ est entièrement réalisée en matériau non-magnétique. Dans ce mode de réalisation, elle est formée d'un empilement de deux sous-couches 54, 56 en matériau non magnétique déposées directement l'une sur l'autre dans la direction Z. Au moins l'une de ces sous-couches est entièrement réalisée dans un matériau choisi dans le groupe constitué des métaux suivants : Ta, Cu, Ru, V, Mo, Hf, Mg, NiCr et NiFeCr. Les alliages NiCr et NiFeCr sont non magnétiques à température ambiante lorsque le chrome est en quantité suffisante.Typiquement, la composition de ces alliages est Ni₁₋ₓCrₓ et [NiFe]₁₋ₓCrₓ, où x est supérieur à 0,2 ou 0,35 et, de préférence, compris entre 0,35 et 0,5.

Par la suite, une sous-couche réalisée dans l'un des matériaux de ce groupe est appelée « sous-couche métallique ». De préférence, la sous-couche métallique est celle qui est directement en contact avec la couche 40 du motif suivant dans la direction Z. Ici, c'est donc la sous-couche 56 qui est la sous-couche métallique. Typiquement, l'épaisseur de la sous-couche métallique est supérieure à 0,5 nm ou 1 nm.

Ici, la sous-couche 54 est aussi une sous-couche métallique réalisée dans un métal différent de la sous-couche 56.

Typiquement, le matériau ou les matériaux de la couche 36 sont choisis pour être adapté à la couche antiferromagnétique basse 40 du motif suivant 342 parmi les matériaux du groupe proposé. Par exemple, si le matériau antiferromagnétique de la couche 40 est du PtMn, au moins l'une des sous-couches de la couche 36 est réalisée en tantale (Ta) ou en [Ni_{1-y}Fe_{y}]₁₋ₓCrₓ. Dans ce dernier cas, de préférence, le pourcentage massique x de chrome dans la sous-couche en NiFeCr est compris entre 35 % et 45 %. De préférence, le pourcentage massique y est compris entre 15 % et 25 %. Par exemple, le pourcentage massique y est égal à 20 %.

Si la couche 40 est en IrMn, on privilégie une couche 36 formée d'une sous-couche en tantale (Ta) et d'une sous-couche en cuivre (Cu) ou d'une sous-couche en tantale et d'une sous-couche en ruthénium(Ru).

Si le matériau antiferromagnétique de la couche 56 contient du manganèse (Mn), avantageusement la couche de croissance 36 comprend au moins une sous-couche en tantale (Ta). Le tantale présente l'avantage de former une barrière de diffusion qui empêche les atomes de manganèse de la couche 40 de diffuser à travers la couche 36₂ lors de la fabrication de l'aimant 20 et notamment lors des étapes de fabrication où les couches antiferromagnétiques sont chauffées à plus de 350°C ou 400°C.

Dans ce mode de réalisation, la sous-couche 56 est réalisée en cuivre et son épaisseur est de 2 nm et la sous-couche 54 est une sous-couche de 5 nm de tantale.

L'épaisseur e₃₆ de la couche 36₂ est supérieure à 0,5 nm ou 1 nm. Il a été observé expérimentalement qu'il existe une relation entre l'épaisseur e₃₆ et le champ H* de l'aimant 20. Plus précisément, cette relation peut être divisée en deux parties :
- une première partie allant de 0,5 nm ou 1 nm jusqu'à une épaisseur critique ec₃₆ dans laquelle plus l'épaisseur e₃₆ augmente plus le champ H* s'éloigne de l'axe des ordonnées, puis
- une deuxième partie qui s'étend au-delà de l'épaisseur critique ec36 dans laquelle l'augmentation de l'épaisseur e₃₆ n'éloigne plus ou très peu le champ H* de l'axe des ordonnées.
Ainsi, de préférence, l'épaisseur e₃₆ est choisie inférieure ou égale à l'épaisseur critique ec₃₆. Cette épaisseur critique ec₃₆ dépend des matériaux utilisés pour réaliser la couche 36₂. En pratique, cette épaisseur critique ec₃₆ est déterminée expérimentalement en essayant différentes épaisseurs e₃₆ possibles pour la couche 36₂ et en mesurant le champ H* obtenu pour cette épaisseur e₃₆. Il est alors possible de construire la relation qui relie l'épaisseur e₃₆ au champ H*. Ensuite, on détermine les deux segments de droite qui constitue la meilleure approximation de cette relation. Le premier segment s'étend entre les points de coordonnées (x1 ; y1) et (x2;y2) et le deuxième segment s'étend entre les points de coordonnées (x2;y2) et (x3;y3). Typiquement, x1 = 1 nm, x2 = ec₃₆ et x3= +oo. La détermination des segments consiste donc à déterminer les valeurs des inconnues y1, x2, y2, y3 qui minimisent, au sens des moindres carrés, les écarts entre ces deux segments et la relation mesurée expérimentalement. L'épaisseur critique ec₃₆ est égale à l'abscisse x2. Généralement, cela conduit à une choix d'une épaisseur e₃₆ inférieure à 10 nm ou 5 nm.

La figure 4 représente un procédé de fabrication de l'aimant permanent 20. Plus précisément, lors d'une étape 70, les différentes couches décrites en référence à la figure 3 sont déposées les unes sur les autres. Pour cela, on utilise des méthodes connues dans le domaine des microtechnologies et de la réalisation des puces électroniques. Lors de l'étape 70, aucune mise en forme particulière n'est donnée à cet empilement de couches. Cet empilement recouvre au moins les emplacements où doivent être réalisés les aimants 20 à 22.

Lors d'une étape 72, cet empilement est structuré pour ne laisser subsister que des empilements en forme de barreau aux emplacements où les aimants 20 à 22 doivent être réalisés. Ainsi, à l'issue de cette étape, il ne subsiste que des barreaux ayant les facteurs de forme requis, c'est-à-dire généralement supérieur à 2, 10 ou 100 voire même supérieur à 100 ou 1000.

Ensuite, lors d'une étape 74, les barreaux sont chauffés pour que la température des couches antiferromagnétiques dépasse leur température de mise en ordre. Ce recuit est effectué sous champ magnétique saturant comme décrit par exemple dans la demande US 2011/0151589. Lors de cette étape, la température peut dépasser 250°C, 350°C ou 400°C.

Ensuite comme décrit par exemple dans la demande US 2011/0151589, lors d'une étape 78, les barreaux sont refroidis sous un champ plus faible jusqu'à ce que les couplages d'échange entre les couches ferromagnétiques et antiferromagnétiques apparaissent et piègent les directions d'aimantation de chaque couche ferromagnétique. On obtient alors les aimants permanents 20 à 22.

Pour les autres étapes de fabrication du capteur 10, le lecteur peut se référer aux demandes de brevet précédemment citées dans l'introduction.

Différents expériences ont été réalisées pour confirmer que l'introduction de la couche de croissance 36 au sein de l'empilement de couches antiferromagnétiques et ferromagnétiques permettait d'améliorer le champ H*. Le tableau ci-dessous résume les résultats expérimentaux obtenus.

| N° aimant | B_{R} (nWb) | Hₑₓ (Oe) | H_{c} (Oe) | Hₑₓ/H_{c} | Hₑₓ-H_{c} | « squareness » | H* (Oe) |
|---|---|---|---|---|---|---|---|
| 1 | 138,3 | 124,6 | 41,3 | 3,07 | 83,3 | 0,9415 | 44 |
| 2 | 193,4 | 144,4 | 23,85 | 6,05 | 120,55 | 0,9962 | 108 |
| 3 | 74,13 | 175,4 | 48,97 | 3,58 | 126,43 | 0,955 | 57 |
| 4 | 73,63 | 191,1 | 44,14 | 4,33 | 146,96 | 0,959 | 86 |
| 5 | 73,01 | 206,9 | 206,9 | 5,23 | 167,36 | 0,967 | 119 |

Dans le tableau ci-dessus, la première colonne comporte le numéro de l'aimant sur lequel les mesures ont été réalisées. Ici, chaque aimant a été réalisé en mettant en oeuvre le procédé de la figure 4 à l'exception de l'étape 72. Ainsi, les aimants testés ne sont pas structurés et ne s'allongent donc pas dans une direction particulière.

Ci-dessous, pour chaque numéro d'aimant, on donne la composition de chaque couche/sous-couche en partant de la couche 36₁ et en allant jusqu'à la couche 38. Dans les lignes ci-dessous, la composition d'une couche est séparée de la composition des couches immédiatement précédente et suivante dans l'empilement par le symbole «/». Le symbole [...]*M indique que l'empilement de couches et sous-couches présent entre les crochets est répété M fois. Le chiffre, qui est séparé de la composition de la couche par un espace, exprime l'épaisseur de cette couche en nanomètre.
Aimant N°1: Ta 5/ Ru 3/ [Ir₂₀Mn₈₀ 10/ Co₄₃Fe₄₃B₁₄ 1/ Fe₆₅Co₃₅ 19/ Ir₂₀Mn₈₀ 10/ Co₄₃Fe₄₃B₁₄ 1/ Fe₆₅Co₃₅ 19/ Ir₂₀Mn₈₀ 10]*12 / Ir₂₀Mn₈₀ 10/ Ta 10.
Aimant N°2 : [Ta 5/ Cu 2/ Ir₂₀Mn₈₀ 7/ Co₄₃Fe₄₃B₁₄ 1/ Fe₆₅Co₃₅ 20/ Ir₂₀Mn₈₀ 7/ Co₄₃Fe₄₃B₁₄ 1/ Fe₆₅Co₃₅ 20/ Ir₂₀Mn₈₀ 7]*8 / Ta 10.
Aimant N°3 : Ta 5/ Ru 3/ Ir₂₀Mn₈₀ 7/ [Co₄₃Fe₄₃B₁₄ 1/ Fe₆₅Co₃₅ 15/ Ir₂₀Mn₈₀ 7]*8 /Ta 10.
Aimant N°4 : [Ta 5/ Ru 3/ Ir₂₀Mn₈₀ 7/ Co₄₃Fe₄₃B₁₄ 1/ Fe₆₅Co₃₅ 15/ Ir₂₀Mn₈₀ 7/ Co₄₃Fe₄₃B₁₄ 1/ Fe₆₅Co₃₅ 15/ Ir₂₀Mn₈₀ 7/ Co₄₃Fe₄₃B₁₄ 1/ Fe₆₅Co₃₅ 15/ Ir₂₀Mn₈₀ 7/ Co₄₃Fe₄₃B₁₄ 1/ Fe₆₅Co₃₅ 15/ Ir₂₀Mn₈₀ 7]*2/ Ta 10.
Aimant N°5 : [Ta 5/ Ru 3/ Ir₂₀Mn₈₀ 7/ Co₄₃Fe₄₃B₁₄ 1/ Fe₆₅Co₃₅ 15/ Ir₂₀Mn₈₀ 7/ Co₄₃Fe₄₃B₁₄ 1/ Fe₆₅Co₃₅ 15/ Ir₂₀Mn₈₀ 7]*4/ Ta 10.

Les aimants N°1 et 3 correspondent à des aimants de l'état de l'art dépourvu de couche intermédiaire située entre deux couches antiferromagnétiques. L'aimant N°2 correspond à l'aimant décrit en référence à la figure 3 dans le cas où le nombre N de motifs 34 est égal à huit. Les aimants N°4 et 5 sont identiques à l'aimant N°3 sauf que, respectivement, une et trois couches de croissance sont introduites dans l'empilement.

Le champ B_{R} du tableau correspond au flux magnétique mesuré en champ nul. Il est exprimé en nano-Weber (nWb). On rappelle que 1 Wb = 1 Tm². Les champs Hₑₓ, H_{c} et H* du tableau sont exprimés en Oersted (Oe). On rappelle que 1 Oe = 1000/(4π) A.m⁻¹. On rappelle également que le champ H* correspond au champ magnétique pour lequel l'hystérésis est inférieure à 2% de la valeur de B_{R}. La colonne « Squareness » contient une valeur qui est d'autant plus élevée que le cycle d'hystérésis de l'aimant est proche d'un rectangle. Cette valeur est calculée à l'aide de la formule suivante : Squareness = (1 - (BR / (SlopeAtH_{c} * H_{c}))), où SlopeAtH_{c} est la pente de la courbe de l'aimantation B en fonction du champ H au niveau du point d'abscisse Hₑₓ - H_{c}.

Les différentes mesures indiquées dans le tableau ont été obtenues à l'aide d'un appareil de mesure connu sous le terme de « BH-Looper ». Ici, il s'agit de l'appareil MESA-200 commercialisé par la société SHB instruments.

Comme le montre les mesurent indiquées dans le tableau, à quantité de matériaux ferromagnétique quasiment identique, l'introduction de la couche de croissance 36 entre la couche antiferromagnétique 48 du motif 34 précédent et la couche antiferromagnétique 40 du motif 34 suivant, permet d'améliorer le champ H* par rapport à un aimant quasiment identique (Aimant N°1 ou 3) mais dépourvu de couches 36. De plus, la présence de la couche 36 permet aussi d'accroître le ratio Hₑₓ/H_{c}. Ainsi, l'aimant permanent 20 présente une insensibilité accrue aux perturbations magnétiques extérieures car le champ H* s'éloigne de l'axe des ordonnées. Cela améliore la dynamique du capteur incorporant cet aimant permanent car le cycle d'hystérésis de l'aimant est plus carré.

Enfin, augmenter le ratio Hₑₓ/H_{c} est également utile pour fabriquer l'aimant 20 avec la forme d'un barreau longiligne. En effet, il est connu que la mise en forme de l'aimant permanent sous la forme d'un barreau longiligne ayant un facteur de forme important augmente la valeur du champ H_{c} alors que le champ Hₑₓ reste constant. Ainsi, si avant une mise en forme le ratio Hₑₓ/H_{c} n'est pas assez important, après mise en forme, le champ H* est très proche de zéro ou supérieur à zéro de sorte que ce barreau aimanté est alors très sensible aux perturbations magnétiques extérieures.

La figure 5 représente un motif 82 apte à remplacer le motif 34 dans l'aimant 20. Le motif 82 est identique au motif 34 sauf que :
- les couches 46 et 48 sont omise, et
- la couche ferromagnétique 42 est remplacée par une couche ferromagnétique 84. La couche 84 est identique à la couche 42 sauf que la sous-couche 50 est omise.

La figure 6 représente un motif 90 apte à remplacer le motif 34 dans l'aimant 20. Le motif 90 est composé successivement dans la direction Z :
- d'une couche antiferromagnétique 91,
- d'une couche ferromagnétique 92 dont la direction d'aimantation est piégée par couplage d'échange avec la couche antiferromagnétique 91,
- d'une couche 94 non-magnétique connue sous le terme de « espaceur » ou « spacer » en anglais,
- d'une couche ferromagnétique 96 dont la direction d'aimantation est piégée par couplage RKKY (Ruderman-Kittel-Kasuya-Yosida) antiferromagnétique avec la couche ferromagnétique 92,
- d'une couche 98 non-magnétique formant un espaceur,
- d'une couche ferromagnétique 100 qui piège, par couplage RKKY antiferromagnétique, la direction d'aimantation de la couche 96, et
- d'une couche antiferromagnétique 102 qui piège la direction d'aimantation de la couche ferromagnétique 100 par couplage d'échange.

La couche 102 est par exemple identique à la couche 91. Ce motif 100 est identique à celui de la figure 3 de la demande FR3020497 sauf qu'il comporte en plus la couche antiferromagnétique 102 située au-dessus de la couche ferromagnétique 100. Pour plus de détails sur la structure et le fonctionnement de ce motif, le lecteur est donc renvoyé à cette demande FR3020497.

Grâce à l'ajout de la couche 102 dans le motif 100, les occurrences 362 à 36N de la couche de croissance 36 sont chacune directement interposée entre la couche antiferromagnétique 102 du motif 90 précédent et la couche antiferromagnétique 91 du motif 90 suivant. Ainsi, comme dans les modes de réalisation précédents, cela améliore le champ H*.

### Variantes des motifs :

Il existe de nombreux autres modes de réalisation possibles pour les motifs. Par exemple, les structures suivantes d'aimants présentent un champ H* amélioré par rapport aux mêmes structures mais dépourvues de couches de croissance :
1) [Ta 3 / Cu 1 / IrMn 7 / FeCo 20 / IrMn 7]*10 / Ta 10
2) [Ta 5 / Cu 2 / IrMn 7 / FeCo 20 / IrMn 7 / FeCo 20 / IrMn 7]*5 / Ta 10
3) [Ta 5 / Ru 3 / IrMn 7 / FeCo 20 / IrMn 7 / FeCo 20 / IrMn 7]*5 / Ta 10
4) Ta 5 / Ru 3 / IrMn 7 / FeCo 20 / IrMn 7 / [Ta 3 / Cu 1 / IrMn 7 / FeCo 20 / IrMn 7 / FeCo 20 / IrMn 7]*4 / Ta 10
5) [Ta 5 / PtMn 20 / CoFeB 1 / CoFe 9]*20 / PtMn 20 / Ta 10.
Les structures ci-dessus sont décrites en utilisant les mêmes notations que celles précédemment introduites. De plus, pour mettre en évidence la couche de croissance dans ces structures, les composants qui la forment sont soulignés. Dans le cas de la structure 4) ci-dessus, les couches initiales « Ta 5 » et « Ru 3 » sont, respectivement, des couches d'accroché et de germination.

Le motif peut comporter encore plus de couches ferromagnétiques et antiferromagnétiques empilées les unes sur les autres que le motif 34. A titre d'illustration, un motif utilisable à la place du motif 34 peut comporter en plus des couches 40, 42, 44, 46 et 48 :
- une couche ferromagnétique supplémentaire déposée sur la couche 48 et dont la direction d'aimantation est figée, par couplage d'échange, avec la couche 48, et
- une couche antiferromagnétique supplémentaire déposée sur la couche ferromagnétique supplémentaire est qui fige elle aussi la direction d'aimantation de cette couche ferromagnétique supplémentaire par couplage d'échange.

Il est possible de combiner, dans un même empilement, des motifs différents. Par exemple, il est possible de construire un empilement en alternant les motifs 34 et 82 ou les motifs 34, 82 et 90.

Le matériau ferromagnétique utilisé pour former la couche ferromagnétique 42, 46, 84, 92, 96 ou 100 peut être différent d'un motif à l'autre dans l'empilement. Par exemple, l'empilement comporte, en alternance, le motifs 82 et un autre motif identique au motif 82 sauf que le matériau ferromagnétique de la couche 84 est du NiFe alors que dans le motif 82 il s'agit du CoFe.

De façon similaire, le matériau antiferromagnétique utilisé pour former la couche 40, 44, 48, 91, 102 d'un motif peut être différent d'un motif à l'autre. Par exemple, dans un motif, ce matériau antiferromagnétique est de l'IrMn et dans un autre motif, il s'agit du PtMn.

L'introduction d'une couche de croissance entre des motifs successifs peut être mise en oeuvre avec tous les motifs décrits dans la demande FR3020497. Pour cela, comme décrit ici dans le cas particulier de la figure 6, il suffit d'ajouter au sommet de chacun des motifs de la demande FR3020497 une couche antiferromagnétique supplémentaire de sorte que chacun de ces motifs débute et termine par une couche antiferromagnétique.

### Variantes de la couche ferromagnétique :

La sous-couche 50 n'est pas nécessairement située au niveau de l'interface avec la couche antiferromagnétique. Par exemple, la couche ferromagnétique 42 comporte trois sous-couches ferromagnétiques empilées directement les unes sur les autres et la sous-couche 50 est placée au milieu de cette empilement de trois sous-couches ferromagnétiques.

Toutes les couches ferromagnétiques de tous les modes de réalisation décrits ici peuvent être réalisées comme la couche 42, c'est-à-dire par un empilement de la sous-couche 50 avec une autre sous-couche ferromagnétique. A l'inverse, la sous-couche 50 peut être omise ou remplacée par une sous-couche d'un autre matériau ferromagnétique dans tous les modes de réalisation décrits ici. Dans une autre variante, c'est la sous-couche 52 qui est omise. Dans ce cas, la couche 42 est entièrement réalisée en CoFeB. L'épaisseur de la couche 42 en CoFeB est alors généralement supérieure à 5 nm ou 10 nm.

Les couches ferromagnétiques ne sont pas nécessairement formées chacune par un seul bloc homogène de matériau ferromagnétique. Par exemple, chaque couche ferromagnétique peut aussi être laminée comme décrit dans la demande de brevet FR 2 892 871 dans le passage page 13, lignes 5 à 9.

### Variantes de la couche antiferromagnétique :

Les couches antiferromagnétiques peuvent elles aussi être formées chacune d'un empilement de plusieurs sous-couches antiferromagnétiques. Par exemple, la couche antiferromagnétique 40, 44 ou 48 est formée d'une sous-couche en IrMn directement déposée sur une sous-couche en PtMn.

### Variantes de la couche de croissance :

L'occurrence 36₁ de la couche de croissance 36 peut être omise. Elle peut aussi être remplacée par une autre couche de germination (« seed layer » en anglais) ou par une couche d'accroché (« Buffer layer » en anglais) ou par une combinaison d'une couche de germination déposée sur une couche d'accroché directement déposée sur le socle 30. La couche de germination peut être, par exemple, une couche en matériau non-magnétique utilisée pour faciliter le dépôt, par exemple par croissance par épitaxie, de la couche 40. La couche de germination est par exemple une couche de Ruthénium de 3 nm d'épaisseur. La couche d'accroché est par exemple une couche de Tantale de 5 nm d'épaisseur. La couche d'accroché est directement déposée sur le socle 30. D'autres variantes sont bien sûr possibles et notamment une unique couche servant à la fois de seed layer et de Buffer layer.

De nombreux autres modes de réalisation de la couche de croissance sont possibles. Par exemple, la sous-couche 52 peut être omise. Dans ce cas, la couche de croissance 36 comporte une seule couche métallique entièrement réalisée avec un seul métal ou un alliage de métaux, ce métal ou chacun des métaux de l'alliage étant choisi dans le groupe constitué des métaux suivants : Ta, Cu, Ru, V, Mo, Hf, Mg, NiCr et NiFeCr. Par exemple, la couche 36 est entièrement et seulement réalisée en tantale. Dans ce dernier cas, avantageusement, la couche antiferromagnétique directement déposée sur cette couche 36 est en PtMn.

La sous-couche métallique 56 n'est pas nécessairement directement en contact avec la couche antiferromagnétique du motif suivant. Par exemple, en variante, l'ordre des sous-couches 54 et 56 est inversé.

De même le nombre de sous-couches utilisées pour former la couche 36 peut être supérieur à trois ou quatre. Dans ce cas, dans un mode de réalisation avantageux, les sous-couches qui sont directement en contact avec, respectivement, la couche 48 du motif précédent et la couche 40 du motif suivant sont des sous-couches métalliques. Entre ces deux sous-couches métalliques, une ou plusieurs des sous-couches intermédiaires sont réalisées en oxyde ou en nitrure. De préférence, lorsque la sous-couche est réalisée en oxyde, celui-ci est choisi dans le groupe constitué des éléments suivants : SiO₂, TiO₂ et Al₂O₃. De préférence, lorsque la sous-couche est réalisée en nitrure, celui-ci est choisi dans le groupe constitué des éléments suivants : SiN, CuN, TiN et TaN.

La sous-couche 54 peut aussi être réalisée en oxyde ou en nitrure.

Les différents exemplaires de la couche de croissance introduit dans l'empilement ne sont pas nécessairement tous identiques. Par exemple, la couche de croissance 36₃ de l'aimant 20 est remplacée par une couche de croissance différente de la couche de croissance 36₂. Par exemple, cette couche de croissance différente est identique à la couche 36₂ sauf que la sous-couche 54 est remplacée par une sous-couche de SiO₂.

Dans un mode de réalisation simplifié, la couche de croissance n'est pas systématiquement introduite entre tous les motifs successifs. Toutefois, une couche de croissance est introduite au moins une fois tous les P motifs successifs ou tous les 2P couches ferromagnétiques successives. Dans ce décompte, seules les couches ferromagnétiques dont les directions d'aimantation sont piégées par couplage d'échange avec une couche antiferromagnétique sont dénombrées. Ainsi, dans ce décompte, une couche ferromagnétique telle que la couche 96 n'est pas comptée. P est inférieur ou égal à dix et, de préférence, inférieure ou égale à quatre ou deux. Ainsi, au moins un dixième, et de préférence au moins un quart ou au moins la moitié, des motifs sont séparés du motif immédiatement suivant par une couche de croissance. Par ailleurs les motifs successifs qui ne sont pas séparés l'un de l'autre par une couche de croissance sont directement empilés les uns sur les autres.

### Autres variantes :

L'empilement n'a pas nécessairement une forme parallélépipédique. Par exemple, la section de l'empilement parallèlement aux directions X, Y est une ellipse ou un ovale. Dans ces derniers cas, le facteur de forme de l'aimant permanent est défini comme étant le rapport de la longueur sur la largeur du parallélépipède de plus petit volume contenant entièrement l'empilement.

En variante, le facteur de forme de l'empilement n'est pas nécessairement supérieur ou égal à deux. Par exemple, il peut être égal à un.

## Revendications

1. Aimant permanent comprenant un empilement de N motifs empilés les uns sur les autres dans une direction d'empilement, où N est un nombre entier supérieur ou égal à deux, chaque motif (34₁-34_{N} ; 82 ; 90) comportant :
- une couche antiferromagnétique basse (40 ; 91),
- une couche antiferromagnétique haute (48 ; 44 ; 102), et
- une couche ferromagnétique (42, 46 ; 84 ; 92, 100) située entre les couches antiferromagnétiques basse et haute et dont la direction d'aimantation est figée, par un couplage d'échange, avec la couche antiferromagnétique basse ou haute de ce motif,
les directions d'aimantation des couches ferromagnétiques (42, 46 ; 84 ; 92, 100), qui sont couplées par couplage d'échange avec la couche antiferromagnétique basse ou haute du même motif, étant toutes identiques les unes aux autres,
**caractérisé en ce que** :
- au moins une fois par groupe de dix couches ferromagnétiques successives dont les directions d'aimantation sont figées par couplage d'échange, l'empilement comporte une couche de croissance (36₂-36_{N}) interposée entre la couche antiferromagnétique haute (48 ; 44 ; 102) du motif précédent et la couche antiferromagnétique basse (40 ; 91) du motif suivant dans la direction d'empilement et cette couche de croissance est directement en contact avec ces deux couches antiferromagnétiques basse et haute entre lesquelles elle est interposée,
- cette couche de croissance est entièrement réalisée dans un matériau non magnétique choisi dans le groupe constitué des métaux suivants : Ta, Cu, Ru, V, Mo, Hf, Mg, NiCr et NiFeCr, ou réalisée par un empilement de plusieurs sous-couches (54, 56) en matériau non magnétique immédiatement déposées les unes sur les autres dans la direction d'empilement, au moins l'une de ces sous-couches (56), appelée « sous-couche métallique », étant entièrement réalisée dans un matériau choisi dans ledit groupe, et
- l'épaisseur de la couche de croissance est supérieure à 0,5 nm.

2. Aimant selon la revendication 1, dans lequel la couche antiferromagnétique (40, 48) comporte du manganèse et la couche de croissance comporte du tantale.

3. Aimant selon la revendication 1 ou 2, dans lequel la couche de croissance est réalisée par l'empilement de plusieurs sous-couches (54, 56) en matériau non magnétique immédiatement déposées les unes sur les autres dans la direction d'empilement et la sous-couche métallique (56) est directement en contact avec la couche antiferromagnétique du motif suivant dans la direction d'empilement.

4. Aimant selon la revendication 3, dans lequel au moins l'une des sous-couches de l'empilement est entièrement en oxyde ou en nitrure.

5. Aimant selon l'une quelconque des revendications précédentes, dans lequel le nombre N est supérieur ou égal à cinq ou dix.

6. Aimant selon l'une quelconque des revendications précédentes, dans lequel l'empilement comporte une couche de croissance (36₂-36_{N}) interposée entre deux motifs successifs de l'empilement au moins une fois par groupe de quatre couches ferromagnétiques successives dont les directions d'aimantation sont figées par couplage d'échange.

7. Aimant selon la revendication 6, dans lequel l'empilement comporte une couche de croissance (36₂-36_{N}) interposée entre chaque motif.

8. Aimant selon l'une quelconque des revendications précédentes, dans lequel le motif (82) comporte une couche antiferromagnétique basse (40) et une couche antiferromagnétique haute (44) et la couche ferromagnétique (84) est interposée entre les couches antiferromagnétiques basse et haute, la direction d'aimantation de la couche ferromagnétique (84) étant figée, par un couplage d'échange, avec les couches antiferromagnétiques basse et haute de ce motif.

9. Aimant selon l'une quelconque des revendications 1 à 7, dans lequel au moins un des motifs (90) comporte une couche ferromagnétique supplémentaire (96) dont la direction d'aimantation est piégée uniquement par couplage RKKY (Ruderman-Kittel-Kasuya-Yosida) avec une autre couche ferromagnétique (92, 100).

10. Aimant selon l'une quelconque des revendications précédentes, dans lequel au moins une des couches ferromagnétiques (42, 46) comporte :
- une première sous-couche (50) réalisée en CoFeB dont l'épaisseur est supérieure à 0,05 nm, et
- une deuxième sous-couche (52) réalisée dans un matériau ferromagnétique différent du CoFeB et dont l'épaisseur est supérieure à l'épaisseur de la première sous-couche.

11. Capteur de champ magnétique comportant :
- un substrat (12) s'étendant essentiellement dans un plan appelé « plan du substrat »,
- au moins un aimant (20-22) permanent déplaçable par rapport au substrat en réponse à une variation de l'amplitude ou de la direction d'un champ magnétique à mesurer,
- un transducteur (24-26) fixé sur le substrat, apte à convertir un déplacement de l'aimant permanent en une grandeur électrique représentative de l'amplitude ou de la direction du champ magnétique à mesurer,
**caractérisé en ce que** l'aimant permanent est conforme à l'une quelconque des revendications précédentes.

12. Procédé de fabrication d'un aimant permanent conforme à l'une quelconque des revendications 1 à 10, ce procédé comportant :
a) la formation (70, 72) d'un empilement comportant N motifs empilés les uns sur les autres dans une direction d'empilement, où N est un nombre entier supérieur ou égal à deux, chaque motif comportant :
- une couche antiferromagnétique basse,
- une couche antiferromagnétique haute, et
- une couche ferromagnétique située entre les couches antiferromagnétiques basse et haute,
b) le chauffage (74) de l'empilement de manière à atteindre une température supérieure à une température de mise en ordre du matériau des couches magnétiques de l'empilement,
c) lorsque la température est supérieure à la température de mise en ordre, l'application (74) d'un premier champ magnétique pour aligner la direction d'aimantation des couches ferromagnétiques sur une direction souhaitée prédéterminée,
d) le refroidissement (78) de l'empilement en présence d'un deuxième champ magnétique inférieur au premier champ magnétique pour faire apparaître un couplage d'échange entre la couche ferromagnétique et la couche antiferromagnétique basse ou haute de ce motif de l'empilement,
caractérisé à ce que l'étape a) comporte également la formation, au moins une fois par groupe de dix couches ferromagnétiques successives dont les directions d'aimantation sont figées par couplage d'échange, d'une couche de croissance interposée entre la couche antiferromagnétique haute du motif précédent et la couche antiferromagnétique basse du motif suivant dans la direction d'empilement,
- cette couche de croissance étant directement en contact avec ces deux couches antiferromagnétiques basse et haute entre lesquelles elle est interposée,
- cette couche de croissance étant entièrement réalisée dans un matériau non magnétique choisi dans le groupe constitué des métaux suivants : Ta, Cu, Ru, V, Mo, Hf, Mg, NiCr et NiFeCr, ou réalisée par un empilement de plusieurs sous-couches en matériau non magnétique immédiatement déposées les unes sur les autres dans la direction d'empilement, au moins l'une de ces sous-couches, appelée « sous-couche métallique », étant entièrement réalisée dans un matériau choisi dans ledit groupe, et
- l'épaisseur de la couche de croissance étant supérieure à 0,5 nm.

## Patentansprüche

1. Dauermagnet, umfassend einen Stapel von N Motiven, die übereinander in einer Stapelrichtung gestapelt sind, wobei N eine ganze Zahl größer oder gleich zwei ist, wobei jedes Motiv (34₁-34_{N}; 82; 90) umfasst:
- eine untere antiferromagnetische Schicht (40; 91),
- eine obere antiferromagnetische Schicht (48; 44; 102), und
- eine ferromagnetische Schicht (42, 46; 84; 92, 100), die sich zwischen den unteren und oberen antiferromagnetischen Schichten befindet, und deren Magnetisierungsrichtung durch eine Austauschkopplung mit der unteren oder oberen antiferromagnetischen Schicht dieses Motivs feststehend ist,
wobei die Magnetisierungsrichtungen der ferromagnetischen Schichten (42, 46; 84; 92, 100), die durch Austauschkopplung mit der unteren oder oberen antiferromagnetischen Schicht desselben Motivs gekoppelt sind, alle zueinander identisch sind,
**dadurch gekennzeichnet, dass**:
- mindestens einmal pro Gruppe von zehn aufeinanderfolgenden ferromagnetischen Schichten, deren Magnetisierungsrichtungen durch Austauschkopplung feststehend sind, der Stapel eine Wachstumsschicht (36₂-36_{N}) umfasst, die zwischen der oberen antiferromagnetischen Schicht (48; 44; 102) des vorherigen Motivs und der unteren antiferromagnetischen Schichte (40; 91) des folgenden Motivs in Stapelrichtung zwischengefügt ist, und diese Wachstumsschicht direkt mit diesen zwei unteren und oberen antiferromagnetischen, zwischen denen sie zwischengefügt ist, in Kontakt ist,
- diese Wachstumsschicht zur Gänze aus einem nicht magnetischen Material hergestellt ist, das in der Gruppe ausgewählt ist, die aus den folgenden Metallen besteht: Ta, Cu, Ru, V, Mo, Hf, Mg, NiCr und NiFeCr, oder durch eine Stapelung von mehreren Unterschichten (54, 56) aus einem nicht magnetischen Material hergestellt ist, die unmittelbar übereinander in Stapelrichtung angeordnet sind, wobei mindestens eine dieser Unterschichten (56), "metallische Unterschicht" genannt, zur Gänze aus einem aus der Gruppe ausgewählten Material hergestellt ist, und
- die Dicke der Wachstumsschicht größer als 5 nm ist.

2. Magnet nach Anspruch 1, bei dem die antiferromagnetische Schicht (40, 48) Mangan umfasst, und die Wachstumsschicht Tantal umfasst.

3. Magnet nach Anspruch 1 oder 2, bei dem die Wachstumsschicht durch Stapelung von mehreren Unterschichten (54, 56) aus einem nicht magnetischen Material hergestellt, die unmittelbar übereinander in Stapelrichtung angeordnet sind, und die metallische Unterschicht (56) direkt mit der antiferromagnetischen Schicht des folgenden Motivs in Stapelrichtung in Kontakt ist.

4. Magnet nach Anspruch 3, bei dem die mindestens eine der Unterschichten des Stapels zur Gänze aus Oxid oder Nitrid ist.

5. Magnet nach einem der vorhergehenden Ansprüche, bei dem die Anzahl N größer oder gleich fünf oder zehn ist.

6. Magnet nach einem der vorhergehenden Ansprüche, bei dem der Stapel eine Wachstumsschicht (36₂-36_{N}) umfasst, die zwischen zwei aufeinanderfolgenden Motiven des Stapels mindestens einmal pro Gruppe von vier aufeinanderfolgenden ferromagnetischen Schichten, deren Magnetisierungsrichtungen durch Austauschkopplung feststehend sind, zwischengefügt ist.

7. Magnet nach Anspruch 6, bei dem der Stapel eine Wachstumsschicht (36₂-36_{N}) umfasst, die zwischen jedem Motiv zwischengefügt ist.

8. Magnet nach einem der vorhergehenden Ansprüche, bei dem das Motiv (82) eine untere antiferromagnetische Schicht (40) und eine obere antiferromagnetische Schicht (44) umfasst, und die ferromagnetische Schicht (84) zwischen den unteren und oberen antiferromagnetischen Schichten zwischengefügt ist, wobei die Magnetisierungsrichtung der ferromagnetischen Schicht (84) durch Austauschkopplung mit den unteren und oberen antiferromagnetischen Schichten dieses Motivs feststehend ist.

9. Magnet nach einem der Ansprüche 1 bis 7, bei dem mindestens eines der Motive (90) eine zusätzliche ferromagnetische Schicht (96) umfasst, deren Magnetisierungsrichtung nur durch RKKY-Kopplung (Ruderman-Kittel-Kasuya-Yosida) mit einer anderen ferromagnetischen Schicht (92, 100) feststehend ist.

10. Magnet nach einem der vorhergehenden Ansprüche, bei dem mindestens eine der ferromagnetischen Schichten (42, 46) umfasst:
- eine erste Unterschicht (50), die aus CoFeB hergestellt ist, deren Dicke größer als 0,05 nm ist, und
- eine zweite Unterschicht (52), die aus einem anderen ferromagnetischen Material als CoFeB hergestellt ist, und deren Dicke größer als die Dicke der ersten Unterschicht ist.

11. Magnetfeldsensor, umfassend:
- ein Substrat (12), das sich im Wesentlichen in einer Ebene, "Substratebene" genannt, erstreckt,
- mindestens einen Dauermagneten (20-22), der in Bezug zum Substrat als Antwort auf eine Veränderung der Amplitude oder der Richtung eines zu messenden Magnetfeldes verschiebbar ist,
- einen Wandler (24-26), der auf dem Substrat befestigt und geeignet ist, eine Verschiebung des Dauermagneten in eine elektrische Größe umzuwandeln, die für die Amplitude oder die Richtung des zu messenden Magnetfeldes repräsentativ ist,
**dadurch gekennzeichnet, dass** der Dauermagnet einem der vorhergehenden Ansprüche entspricht.

12. Verfahren zur Herstellung eines Dauermagneten nach einem der Ansprüche 1 bis 10, wobei dieses Verfahren umfasst:
a) die Bildung (70, 72) eines Stapels, umfassend N übereinander in Stapelrichtung gestapelte Motive, wobei N eine ganze Zahl größer oder gleich zwei ist, wobei jedes Motiv umfasst:
- eine untere antiferromagnetische Schicht,
- eine obere antiferromagnetische Schicht, und
- eine ferromagnetische Schicht, die sich zwischen den unteren und oberen antiferromagnetischen Schichten befindet,
b) die Erhitzung (74) des Stapels, um eine Temperatur über einer Ordnungstemperatur des Materials der magnetischen Schichten des Stapels zu erreichen,
c) wenn die Temperatur höher als die Ordnungstemperatur ist, Anlegen (74) eines ersten Magnetfeldes, um die Magnetisierungsrichtung der ferromagnetischen Schichten auf einer vorbestimmten gewünschten Richtung auszurichten,
d) Kühlen (78) des Stapels bei Vorhandensein eines zweiten Magnetfeldes kleiner als das erste Magnetfeld, um eine Austauschkopplung zwischen der ferromagnetischen Schicht und der unteren oder oberen antiferromagnetischen Schicht dieses Motivs des Stapels auftreten zu lassen,
**dadurch gekennzeichnet, dass** der Schritt a) mindestens einmal pro Gruppe von zehn aufeinanderfolgenden ferromagnetischen Schichten, deren Magnetisierungsrichtungen durch Austauschkopplung feststehend sind, auch die Bildung einer Wachstumsschicht umfasst, die zwischen der oberen antiferromagnetischen Schicht des vorherigen Motivs und der unteren antiferromagnetischen Schicht des folgenden Motivs in Stapelrichtung zwischengefügt ist,
- wobei diese Wachstumsschicht direkt mit diesen zwei unteren und oberen antiferromagnetischen Schichten, zwischen denen sie zwischengefügt ist, in Kontakt ist,
- wobei diese Wachstumsschicht zur Gänze aus einem nicht magnetischen Material hergestellt ist, das in der Gruppe ausgewählt ist, die aus den folgenden Metallen besteht: Ta, Cu, Ru, V, Mo, Hf, Mg, NiCr und NiFeCr, oder durch eine Stapelung von mehreren Unterschichten (54, 56) aus einem nicht magnetischen Material hergestellt ist, die unmittelbar übereinander in Stapelrichtung angeordnet sind, wobei mindestens eine dieser Unterschichten, "metallische Unterschicht" genannt, zur Gänze aus einem aus der Gruppe ausgewählten Material hergestellt ist, und
- die Dicke der Wachstumsschicht größer als 0,5 nm ist.

## Claims

1. Permanent magnet comprising a stack of N patterns stacked one on top of another in a stack direction, where N is a whole number greater than or equal to two, each pattern (34₁-34_{N} ; 82 ; 90) comprising:
- a bottom antiferromagnetic layer (40 ; 91),
- a top antiferromagnetic layer (48 ; 44 ; 102), and
- a ferromagnetic layer (42, 46 ; 84 ; 92, 100) situated between the bottom and top antiferromagnetic layers and whose direction of magnetization is frozen, by an exchange coupling, with the bottom or top antiferromagnetic layer of this pattern,
the directions of magnetization of the ferromagnetic layers (42, 46 ; 84 ; 92, 100) which are coupled by exchange coupling with the bottom or top antiferromagnetic layer of the same pattern being all identical to each other,
**characterized in that**:
- at least once per group of ten consecutive ferromagnetic layers whose directions of magnetization are frozen by exchange coupling, the stack comprises a growth layer (36₂-36_{N}) interposed between the top antiferromagnetic layer (48 ; 44 ; 102) of the previous pattern and the bottom antiferromagnetic layer (40; 91) of the following pattern in the stack direction and this growth layer is directly in contact with these two top and bottom antiferromagnetic layers between which it is interposed,
- this growth layer is entirely realized in a nonmagnetic material chosen from the group made up of the following metals: Ta, Cu, Ru, V, Mo, Hf, Mg, NiCr and NiFeCr, or it is realized by a stack of several sublayers (54, 56) of nonmagnetic material disposed immediately on one another in the stack direction, at least one of these sublayers (56), known as the "metallic sublayer", being entirely realized in a material chosen from said group, and
- the thickness of the growth layer is greater than 0.5 nm.

2. Magnet according to Claim 1, wherein the antiferromagnetic layer (40, 48) comprises manganese and the growth layer comprises tantalum.

3. Magnet according to Claim 1 or 2, wherein the growth layer is realized by the stack of several sublayers (54, 56) of non-magnetic material deposited immediately on one another in the stack direction and the metallic sublayer (56) is directly in contact with the antiferromagnetic layer of the next pattern in the stack direction.

4. Magnet according to Claim 3, wherein at least one of the sublayers of the stack is entirely composed of oxide or nitride.

5. Magnet according to any one of the preceding claims, wherein the number N is greater than or equal to five or ten.

6. Magnet according to any one of the preceding claims, wherein the stack comprises a growth layer (36₂-36_{N}) interposed between two consecutive patterns of the stack at least once per group of four consecutive ferromagnetic layers whose directions of magnetization are frozen by exchange coupling.

7. Magnet according to Claim 6, wherein the stack comprises a growth layer (362-36_{N}) interposed between each pattern.

8. Magnet according to any one of the preceding claims, wherein the pattern (82) comprises a bottom antiferromagnetic layer (40) and a top antiferromagnetic layer (44) and the ferromagnetic layer (84) is interposed between the bottom and top antiferromagnetic layers, the direction of magnetization of the ferromagnetic layer (84) being frozen, by an exchange coupling with the bottom and top antiferromagnetic layers of this pattern.

9. Magnet according to any one of Claims 1 to 7, wherein at least one of the patterns (90) comprises a supplemental ferromagnetic layer (96) whose direction of magnetization is trapped solely by RKKY (Ruderman-Kittel-Kasuya-Yosida) coupling with another ferromagnetic layer (92, 100).

10. Magnet according to any one of the preceding claims, wherein at least one of the ferromagnetic layers (42, 46) comprises:
- a first sublayer (50) realized in CoFeB whose thickness is greater than 0.05 nm, and
- a second sublayer (52) realized in a ferromagnetic material different from CoFeB and whose thickness is greater than the thickness of the first sublayer.

11. Magnetic field sensor comprising:
- a substrate (12) extending substantially in a plane called the "plane of the substrate",
- at least one permanent magnet (20-22) movable in relation to the substrate in response to a variation in the amplitude or the direction of a magnetic field to be measured,
- a transducer (24-26) secured to the substrate, able to convert a movement of the permanent magnet into an electrical quantity representative of the amplitude or the direction of a magnetic field to be measured,
**characterized in that** the permanent magnet is consistent with any one of the preceding claims.

12. Method of fabrication of a permanent magnet according to any one of claims 1 to 10, this method involving:
a) the formation (70, 72) of a stack comprising N patterns stacked one upon the other in a stack direction, where N is a whole number greater than or equal to two, each pattern comprising:
- a bottom antiferromagnetic layer,
- a top antiferromagnetic layer, and
- a ferromagnetic layer situated between the bottom and top antiferromagnetic layers,
b) the heating (74) of the stack so as to achieve a temperature greater than a temperature of ordering of the material of the magnetic layers of the stack,
c) when the temperature is greater than the temperature of ordering, the application (74) of a first magnetic field to align the direction of magnetization of the ferromagnetic layers with a predetermined desired direction,
d) the cooling (78) of the stack in the presence of a second magnetic field less than the first magnetic field to cause an exchange coupling to appear between the ferromagnetic layer and the bottom or top antiferromagnetic layer of this pattern of the stack,
**characterized in that** step a) likewise involves the formation, at least once per group of ten consecutive ferromagnetic layers whose directions of magnetization are frozen by exchange coupling, of a growth layer interposed between the top antiferromagnetic layer of the previous pattern and the bottom antiferromagnetic layer of the following pattern in the stack direction,
- this growth layer being directly in contact with these two top and bottom antiferromagnetic layers between which it is interposed,
- this growth layer being entirely realized in a nonmagnetic material chosen from the group made up of the following metals: Ta, Cu, Ru, V, Mo, Hf, Mg, NiCr and NiFeCr, or realized by a stack of several sublayers of nonmagnetic material disposed immediately on one another in the stack direction, at least one of these sublayers, known as the "metallic sublayer", being entirely realized in a material chosen from said group, and
- the thickness of the growth layer being greater than 0.5 nm.
